# EUROPÄISCHE PATENTANMELDUNG

(11) **EP 3 750 628 A1**
(43) Veröffentlichungstag der Anmeldung: **16.12.2020**
(21) Anmeldenummer: 19180300.6
(22) Anmeldetag: 14.06.2019
(51) Int. Cl.: B01L 3/00, B29C 65/52, B01F 13/00

(54) **FLUIDLEITUNGSTEIL FÜR EINE MIKROFLUIDISCHE VORRICHTUNG, MIKROFLUIDISCHE VORRICHTUNG UND VERFAHREN ZUR FERTIGUNG EINER MIKROFLUIDISCHEN VORRICHTUNG**

(71) Anmelder: IMT AG, 8606 Greifensee (CH)
(72) Erfinder: Bauert, Tobias, 8486 Rikon im Tösstal (CH); Sanz-Velasco, Anke, 5400 Baden (CH)
(74) Vertreter: Maikowski & Ninnemann Patentanwälte Partnerschaft mbB

(57) **Zusammenfassung**

Vorgeschlagen wird ein Fluidleitungsteil (31) für eine mikrofluidische Vorrichtung (3). Das Fluidleitungsteil (31) umfasst ein erstes Substrat (310) mit einer ersten Oberfläche (3101), in der wenigstens eine Vertiefung (3102) ausgebildet ist, wobei die wenigstens eine Vertiefung (3102) einen Kanal (K) zum Leiten eines Fluids entlang einer Hauptstromrichtung (X) ausbildet; sowie wenigstens einen Stützsteg (3103), der sich innerhalb des Kanals (K) der Länge nach entlang der Hauptstromrichtung (X) erstreckt. Dabei ist der mindestens eine Stützsteg (3103) in der Weise ausgebildet und angeordnet, dass er von dem Fluid frei umströmt wird.

## Beschreibung

Diese Schrift betrifft Ausführungsformen eines Fluidleitungsteils für eine mikrofluidische Vorrichtung, Ausführungsformen einer mikrofluidischen Vorrichtung mit einem solchen Fluidleitungsteil sowie Ausführungsformen eines Verfahrens zur Fertigung einer mikrofluidischen Vorrichtung.

Mikrofluidischen Vorrichtungen sind ausgebildet, Fluide, insbesondere Flüssigkeiten, in Strukturen wie z. B. Kavitäten und Kanälen, die wenigstens teilweise Abmessungen im Mikrometerbereich (wie von wenigen Mikrometern bis zu einigen hundert Mikrometer) haben, aufzunehmen und/oder zu leiten. Beispielsweise werden mikrofluidische Vorrichtungen in Form von sogenannten "Lab-on-a-Chip"-Systemen für medizintechnische oder allgemein biotechnologische Anwendungen eingesetzt. Es ist ferner bekannt, mikrofluidische Vorrichtungen in Form von sogenannten "Flow cells" z.B. für diagnostische Zwecke und speziell für die DNA-Sequenzierung verwendet.

Unter einem Fluidleitungsteil soll im Rahmen der vorliegenden Schrift einer Komponente für eine mikrofluidische Vorrichtung verstanden werden, welche wenigstens einen Kanal zum Leiten eines Fluides bereitstellt. Dabei weist der Kanal in wenigstens einer Dimension (wie z. B. einer Kanaltiefe) Abmessungen im Mikrometerbereich auf, wie etwa von wenigen Mikrometern bis zu einigen hundert Mikrometern, auf. Es soll jedoch beachtet werden, dass ein derartiges Fluidleitungsteil nicht in dem Sinne mikrostrukturiert sein muss, dass sämtliche Abmessungen der darin ausgebildeten Kanäle im Mikrometerbereich liegen müssen; vielmehr kann ein in einem Fluidleitungsteil ausgeformter Kanal beispielsweise eine Kanaltiefe im Mikrometerbereich (z. B. bis zu 100 µm) aufweisen, wohingegen eine Kanalbreite und/oder eine Kanallänge im Millimeter- oder sogar Zentimeterbereich liegen kann.

Ein derartiges Fluidleitungsteil umfasst ein erstes Substrat mit einer ersten Oberfläche, in der wenigstens eine Vertiefung ausgebildet ist, wobei die wenigstens eine Vertiefung einen Kanal zum Leiten eines Fluides entlang einer Hauptstromrichtung ausbildet.

Üblicherweise wird ein solches Fluidleitungsteil nach oben hin mittels eines Verschlussteils abgeschlossen, um eine mikrofluidische Vorrichtung auszubilden. Insbesondere wird dabei der mindestens eine Kanal nach oben hin teilweise fluiddicht abgeschlossen.

Dabei sind im Rahmen der vorliegenden Beschreibung Angaben wie "nach oben", "oberer", "auf", "nach unten", "unterer" etc. lediglich relative Angaben, die bei einmal festgelegten Bezugssystem räumliche Beziehungen verschiedener Komponenten zueinander bezeichnen, aber keine absolute Orientierung im Raum festlegen.

Beispielsweise können das Fluidleitungsteil und/oder das Verschlussteil jeweils auf einem Wafer (z. B. aus Glas oder Silizium) ausgebildet sein. In diesem Fall können die beiden Wafer beispielsweise durch sogenanntes "Klebebonden" aufeinander geklebt werden, wodurch der Kanal in dem Fluidleitungsteil mittels des Verschlussteils nach oben verschlossen wird. Beim Klebebonden kann also mittels eines dünnen Klebstofffilms eine flächige Verbindung zwischen zwei Wafern (wie z. B. Glaswafern) geschaffen werden. Diese Form der Verbindungstechnik wird insbesondere bei Komponenten eingesetzt, die in nachfolgenden Prozessschritten keinen erhöhten Temperaturen ausgesetzt werden dürfen, z. B. weil bereits Metalle oder biologische Funktionsstrukturen vorhanden sind, welche kein höheres Temperaturbudget vertragen.

Der wenigstens eine Kanal des Fluidleitungsteils darf beim Klebebonden nicht mit Klebstoff kontaminiert werden, um die Funktion der mikrofluidischen Vorrichtung nicht zu beeinträchtigen. Eine Herausforderung beim Klebebonden besteht somit in dem Aufbringen einer homogenen, großflächigen Klebstoffschicht auf die Oberfläche eines Substrats unter Vermeidung einer Kontaminierung von (den oder die Kanäle ausbildenden) Vertiefungen der Substratoberfläche mit dem Klebstoff.

Herkömmlich wird dies durch das Aufbringen des Klebstoffs mittels Klebstoffübertrag von einer mit dem Klebstoff beschichteten Folie auf einen strukturierten Wafer ermöglicht. Dabei wird die Folie üblicherweise in einem Rahmen fixiert und z. B. mittels einer Walze auf der Waferoberfläche abgerollt.

Bei dieser Technik stellen jedoch besonders flache und zugleich breite Vertiefungen ein Problem dar, da bei einem geringen Tiefe-zu-Breite Verhältnis nicht verhindert werden kann, dass Klebstoff von der Folie in die Vertiefungen übertragen wird und somit die Kanäle kontaminiert werden. Dies kann zur Unbrauchbarkeit der gesamten mikrofluidischen Vorrichtung führen.

Es ist bekannt, das vorstehend geschilderte Problem zu umgehen, indem der Klebstoffübertrag nicht durch das großflächige Abrollen einer Folie, sondern mittels eines ortsaufgelösten Systems, wie z. B. mittels eines Klebedispensers oder in einer Art Tintenstrahldruckerverfahren ausgeführt wird.

Als eine alternative Lösung schlägt die US 8,647,465 B2 vor, Klebstoff zunächst auf ein oberhalb einer Waferoberfläche gespanntes engmaschiges Gitter mit gleichmäßig beabstandeten Löchern in der Weise aufzutragen, dass jedes Loch einen Tropfen Klebstoff aufnimmt, und sodann die Unterseite des Gitters mit der Substratoberfläche in Kontakt zu bringen, wobei der Klebstoff durch die Löcher hindurch auf die Substratoberfläche aufgebracht wird, ohne dass Klebstoff in Ausnehmungen in der Substratoberfläche eintritt.

Die vorgenannten im Stand der Technik bekannten Verfahren sind vergleichsweise aufwendig und dementsprechend kostenintensiv.

Hiervon ausgehend stellt sich die vorliegende Erfindung die Aufgabe, ein Fluidleitungsteil für eine mikrofluidische Vorrichtung vorzuschlagen, welches einen vereinfachten Stoffübertrag im Rahmen eines Klebebondverfahrens ermöglicht, wobei eine Kontamination eines Kanals des Fluidleitungsteils auch bei einem vergleichsweise geringen Tief-zu-Breite-Verhältnis des Kanals verhindert wird.

Aufgabe der vorliegenden Erfindung ist es weiter, eine entsprechende mikrofluidische Vorrichtung sowie ein entsprechendes Fertigungsverfahren vorzuschlagen.

Zur Lösung dieser Aufgabe werden die Gegenstände der unabhängigen Ansprüche vorgeschlagen. Merkmale einiger Ausführungsbeispiele sind in den Unteransprüchen angegeben. Die Merkmale der Unteransprüche können miteinander zur Ausbildung weiterer Ausführungsformen kombiniert werden, sofern nicht ausdrücklich etwas anderes angegeben ist.

Gemäß einem ersten Aspekt umfasst ein Fluidleitungsteil der eingangs genannten Art ferner wenigstens einen Stützsteg, der sich innerhalb des Kanals der Länge nach entlang der Hauptstromrichtung erstreckt, wobei der Stützsteg in der Weise ausgebildet und angeordnet ist, dass er von dem Fluid frei umströmt wird.

Gemäß einem zweiten Aspekt umfasst eine mikrofluidische Vorrichtung ein Fluidleitungsteil entsprechend dem ersten Aspekt sowie ein Verschlussteil, das ein zweites Substrat mit einer zweiten Oberfläche umfasst, wobei die zweite Oberfläche wenigstens abschnittsweise auf die erste Oberfläche aufgeklebt ist.

Gemäß einem dritten Aspekt wird ein Verfahren zur Fertigung einer mikrofluidischen Vorrichtung vorgeschlagen. Das Verfahren umfasst zunächst das Bereitstellen eines Fluidleitungsteils, wobei das Fluidleitungsteil folgendes umfasst: ein erstes Substrat mit einer ersten Oberfläche, in der wenigstens eine Vertiefung ausgebildet ist, wobei die wenigstens eine Vertiefung einen Kanal zum Leiten eines Fluides entlang einer Hauptstromrichtung ausbildet; und wenigstens einen frei vom Fluid umströmten Stützsteg innerhalb des Kanals. Das Verfahren umfasst ferner das Auftragen von Klebstoff auf die erste Oberfläche durch Abrollen einer mit dem Klebstoff beschichteten Folie auf der ersten Oberfläche, wobei der Stützsteg verhindert, dass die mit Klebstoff beschichtete Folie mit einem Boden des Kanals in Kontakt kommt.

Nachstehend wird auf alle vorstehend genannten Aspekte Bezug genommen werden.

Durch das Vorsehen des wenigstens einen Stützstegs in dem Kanal kann auch bei einem - mit Blick auf einen Klebeübertrag mittels einer mit Klebstoff beschichteten Folie - ungünstigen (besonders geringen) Tiefe-zu-Breite-Verhältnis des Kanals, d.h. z. B. bei sehr flachen und breiten Vertiefungen, verhindert werden, dass der Klebstoff den funktionalen Kanal kontaminiert. Dies wird dadurch bewerkstelligt, dass der wenigstens eine Stützsteg die Folie während des Abrollen stützt und sie so von dem Boden des Kanals fernhält.

Der oder die Stützstege sind in dem Kanal so angeordnet, dass sie frei umströmt werden. Dies bedeutet, dass sie nicht etwa einen Fluidstrom über das gesamte Fluidleitungsteil hinweg in mehrere gänzlich separate Kanäle aufteilen; vielmehr werden sie innerhalb des Kanals von dem Fluid angeströmt (d.h. sie haben eine entgegen die Hauptstromrichtung gerichtete Anströmkante), sodass sie den Fluidstrom abschnittsweise aufteilen, wobei der Fluidstrom nach dem Passieren des oder der Stützstege innerhalb des Kanals wieder zusammengeführt wird. Insbesondere kann der wenigstens eine Stützsteg so ausgeformt sein, dass er von dem Fluid frei umströmt wird und dabei dem Fluid allenfalls einen geringen Strömungswiderstand entgegensetzt.

Dabei kann z. B. durch eine im Vergleich zu der Kanalbreite geringe Stützstegbreite (wobei die Kanalbreit und die Stützstegbreite quer zu der Hauptstromrichtung und damit zu einer Längserstreckung des Stützstegs gemessen werden) erreicht werden, dass die fluidischen Eigenschaften des in dem Fluidleitungsteil ausgebildeten Kanals nicht oder nur minimal negativ beeinflusst werden. Beispielsweise beträgt bei einer vorteilhaften Ausführungsform eine Stützstegbreite des wenigstens einen Stützstegs höchstens ein Zehntel einer Kanalbreite des Kanals im Bereich des wenigstens einen Stützstegs.

Mit der Angabe, dass der Stützsteg sich seiner Länge nach entlang der Haupterstromrichtung erstreckt, ist gemeint, dass der Stützsteg entlang jener Hauptstromrichtung eine größere Abmessung aufweist als quer zu der Hauptstromrichtung. Mit anderen Worten ist eine Stützsteglänge (entlang der Hauptstromrichtung) größer als die Stützstegbreite (quer zu der Hauptstromrichtung). Bei bevorzugten Ausführungsformen beträgt ein Länge-zu-Breite-Verhältnis des Stützstegs beispielsweise wenigstens 10, insbesondere wenigstens 33, wie z. B. wenigstens 50.

Bei einer Ausführungsform ist eine Stützsteghöhe des mindestens einen Stützstegs gleich einer Tiefe des Kanals. In anderen Ausführungsformen kann die Stützsteghöhe jedoch auch kleiner als die Tiefe des Kanals sein.

Ein Verhältnis der Stützstegbreite zu einer Stützsteghöhe ist bevorzugt größer als 1, insbesondere größer als 2, wie z. B. größer als 10.

Nach einer bevorzugten Ausführungsform weist der wenigstens eine Stützsteg an einem gegen die Hauptstromrichtung weisenden Ende eine abgerundete Anströmkante auf. Beispielsweise kann die Anströmkante in einer Draufsicht auf den Stützsteg halbkreisförmig (z. B. mit der halben Stützstegbreite als Radius) ausgeformt sein. Hierdurch kann ein vergleichsweise geringer Strömungswiderstand des Stützstegs erreicht werden. Somit kann die abgerundete Anströmkante dazu beitragen, dass der Stützsteg frei umströmt wird und dabei die fluidischen Eigenschaften des Kanals möglichst wenig beeinflusst.

Bei einer vorteilhaften Variante ist auch das jeweils andere Ende des Stützstegs, also das in die Hauptstromrichtung weisenden Ende, mit einer solchen abgerundeten Kante versehen. Dies kann zu einer besonders widerstandsarmen, laminaren Umströmung des Stützstegs beitragen. Insbesondere kann durch abgerundete Anströmkanten einer Vermeidung von Verwirbelungen des Fluides im Bereich des Stützstegs beigetragen werden. Ferner kann durch eine solche in die Hauptstromrichtung weisende abgerundete Kannte ein Anhaften von Blasen an jener Kante verhindert oder erschwert werden.

Gemäß einer Ausführungsform sind zwei oder mehr (wie z. B. drei) derartige Stützstege vorgesehen, die sich nebeneinander in dem Kanal erstrecken. Hierdurch kann auch bei einem sehr breiten Kanal und bei einer vergleichsweise geringen Kanaltiefe verhindert werden, dass die Folie beim Klebstoffübertrag einen Boden des Kanals berührt und dabei eine Kontamination mit Klebstoff hinterlässt.

Es liegt auch im Rahmen der Erfindung, dass der oder die Stützstege den Kanal in einem Querschnitt senkrecht zu der Hauptstromrichtung in mehrere gleich breite Unterkanäle unterteilen kann bzw. können. Dabei können die Unterkanäle seitlich etwa von einer Seitenwand des Kanals und einer Seitenwand eines Stützstegs oder (sofern mindestens zwei nebeneinander verlaufende Stützstege vorgesehen sind) von zwei Seitenwänden benachbarter Stützstege begrenzt werden. Durch eine äquidistante Positionierung des Stützstegs bzw. der mehreren Stützstege über die Breite des Kanals hinweg kann eine möglichst gute Stützwirkung für die Folie beim Klebstoffübertrag erreicht werden, sodass man bei vorgegebener Kanalbreite und -tiefe mit einer möglichst geringen Anzahl solcher Stützstege auskommt.

Hinsichtlich der Abmessungen des Kanals ist gemäß einer bevorzugten Ausführungsform vorgesehen, dass eine Tiefe des Kanals kleiner oder gleich 75 µm, insbesondere kleiner oder gleich 50 µm, wie z. B. kleiner oder gleich 5 µm ist.

Bezüglich der Kanalbreite sieht eine Ausführungsform vor, dass diese wenigstens 1,0 mm, insbesondere wenigstens 2,5 mm, wie z. B. wenigstens 5,0 mm beträgt.

Bei einem vergleichsweise geringen Tiefe-zu-Breite-Verhältnis, wie es etwa durch die Kombination der vorstehend erwähnten bevorzugten Ausführungsformen (mit einer Kanaltiefe von weniger als 75 µm und einer Kanalbreite von wenigstens 2,5 mm) gegeben ist, würde in Abwesenheit eines oder mehrerer Stützstege die Gefahr eines Kontakts der Folie mit dem Kanalboden und damit einer Kontamination des Kanals durch Klebstoff bestehen. Dies wird jedoch gerade durch den erfindungsgemäßen wenigstens einen Stützsteg verhindert. Somit ermöglicht die Erfindung eine Herstellung einer mikrofluidischen Vorrichtung mittels Klebebonden auch mit derartig breiten und flachen Kanälen. Dies ermöglicht in vorteilhafter Weise insbesondere die Realisierung homogen gefügter, spannungsarmer mikrofluidischer Komponenten, die keinen hohen Temperaturen ausgesetzt wurden.

Der wenigstens eine Stützsteg ist bevorzugt mit dem ersten Substrat in einem Stück ausgebildet. Dies bedeutet, dass der wenigstens eine Stützsteg z. B. gemeinsam mit dem Kanal einstückig aus dem ersten Substrat gefertigt werden kann.

Vorzugsweise wird zu diesem Zweck eine Vertiefung, die den Kanal ausbildet, mittels eines Ätzprozesses erzeugt, wobei der Arbeitsprozess derart ausgeführt wird, dass der wenigstens eine Stützsteg stehen bleibt. Beispielsweise kann hierfür in an sich bekannter Weise auf die Techniken der Fotolithografie gegriffen werden, mittels derer kleine Strukturen wie die den Kanal ausbildende Ausnehmung sowie der wenigstens eine Stützsteg hinreichend präzise definiert werden können.

In einer Variante umfasst das Verfahren gemäß dem zweiten Aspekt zusätzlich das Bereitstellen eines Verschlussteils, das ein zweites Substrat mit einer zweiten Oberfläche umfasst und das Aufkleben der zweiten Oberfläche des Verschlussteils auf die erste Oberfläche des Fluidleitungsteils mittels des Klebstoffs. Dabei kann z. B. vorgesehen sein, dass mehrere derartige Fluidleitungsteile auf einem ersten Wafer bereitgestellt werden und dass mehrere derartige Verschlussteile auf einem zweiten Wafer bereitgestellt werden. Sodann wird der zweite Wafer im Ganzen auf den ersten Wafer geklebt. Hierdurch können in besonders effizienter Weise in einem Schritt mehrere mikrofluidische Vorrichtungen gefertigt werden. Eine Vereinzelung der miteinander verklebten Wafer in mehrere mikrofluidische Vorrichtungen (etwa durch einen Säge- oder Lasertrennprozess) kann im Anschluss an das Klebebonden erfolgen.

Das Verschlussteil kann eine unstrukturierte Oberfläche aufweisen, die auf das Fluidleitungsteil geklebt wird und den Kanal lediglich nach Art eines Deckels nach oben abschließt. Alternativ kann die Oberfläche des Verschlussteils aber auch strukturiert sein und etwa eine oder mehrere Vertiefungen aufweisen, welche einen oder mehrere Kanäle für das Fluid bilden. Demnach kann das Verschlussteil in funktionaler Hinsicht ebenso gut zum Leiten eines Fluids ausgebildet sein wie das Fluidleitungsteil. Die Anordnung von Vertiefungen in dem Fluidleitungsteil und dem Verschlussteil kann derart aufeinander abgestimmt sein, dass nach dem Klebebonden die Vertiefungen in dem Fluidleitungsteil und die Vertiefungen in dem Verschlussteil gemeinsam einen oder mehrere Kanäle ausbilden.

Als Materialien für das erste Substrat und/oder das zweite Substrat kommen bevorzugt Glas, Silizium oder Kunststoff in Frage. Insbesondere Glas und Silizium eignen sich für die vorstehend erläuterte Herstellungsvariante mittels eines oder mehrerer miteinander verklebter Wafer.

Es soll verstanden werden, dass das Verfahren gemäß dem dritten Aspekt insbesondere auf die Fertigung einer mikrofluidischen Vorrichtung entsprechend dem zweiten Aspekt gerichtet sein kann. Dementsprechend ist das vorstehend und nachfolgend mit Bezug auf das Verfahren gemäß dem dritten Aspekt Erläuterte analog auf die mikrofluidische Vorrichtung gemäß dem zweiten Aspekt bzw. auf das Fluidleitungsteil gemäß dem ersten Aspekt anwendbar, und umgekehrt.

Weitere Einzelheiten und Vorteile der Erfindung werden bei der nachfolgenden Beschreibung einiger Ausführungsbeispiele anhand der Figuren deutlich werden.

Es zeigen:
- Fig. 1: schematisch und exemplarisch einen Klebstoffübertrag bei einem herkömmlichen Fluidleitungsteil für eine mikrofluidische Vorrichtung;
- Fig. 2: schematisch und exemplarisch einen Klebstoffübertrag bei einem herkömmlichen Fluidleitungsteil für eine mikrofluidische Vorrichtung, wobei es zu einer Kontamination eines Fluidkanals mit Klebstoff kommt.;
- Fig. 3: schematisch und exemplarisch einen Klebstoffübertrag bei einem Fluidleitungsteil für eine mikrofluidische Vorrichtung gemäß einer Ausführungsform der Erfindung.;
- Fig. 4: schematisch und exemplarisch eine Ausführungsform einer mikrofluidischen Vorrichtung mit einem Fluidleitungsteil und einem darauf geklebten Verschlussteil; und
- Fig. 5: schematisch und exemplarisch eine Ausführungsform eines erfindungsgemäßen Fluidleitungsteils in einer Draufsicht;

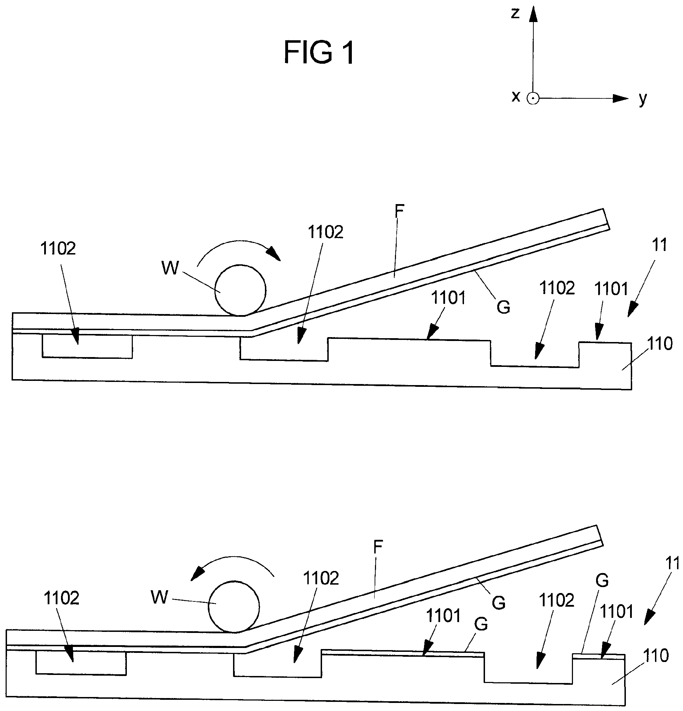

Fig. 1 veranschaulicht schematisch und exemplarisch den Vorgang eines Klebstoffübertrags bei einem herkömmlichen Fluidleitungsteil 11 für eine mikrofluidische Vorrichtung. Genauer gesagt ist eine Querschnittsansicht eines Fluidleitungsteils 11 entlang einer Richtung Y gezeigt, die senkrecht zu einer Hauptstromrichtung X in dem Fluidleitungsteil 11 verläuft.

Das Fluidleitungsteil 11 umfasst ein Substrat 110, in dessen oberer Oberfläche 1101 mehrere Vertiefungen 1102 ausgebildet sind. Die Vertiefungen 1102 definieren Kanäle, die ein Fluid entlang der Hauptstromrichtung X leiten.

Üblicherweise wird ein solches Fluidleitungsteil 11 mittels eines (hier nicht dargestellten) Verschlussteils verschlossen, um die Kanäle 1102 nach oben hin abzudichten. Hierfür wird das Verschlussteil z. B. mittels Klebebonden auf das Fluidleitungsteil 11 geklebt.

Wie in der Fig. 1 in zwei Schritten schematisch veranschaulicht, wird dabei zunächst mittels einer mit dem Klebstoff G beschichteten Folie F ein dünner Klebstoffilm G auf die strukturierte Oberfläche 1101 übertragen. Die in einem Rahmen fixierte Folie F wird mittels einer Walze W auf der Oberfläche 1101 abgerollt (Rollbewegung der Walze W nach rechts im oberen Teil der Fig. 1), sodass die verschiedenen koplanaren Abschnitte der Oberfläche 1101 mit Klebstoff G benetzt werden. Sodann wird die Folie F entfernt (Rollbewegung der Walze W nach links im unteren Teil der Fig. 1), sodass ein dünner Klebstofffilm G auf der Oberfläche 1101 freiliegt. Auf diesen Klebstoffilm kann sodann das Verschlussteil geklebt werden (nicht dargestellt).

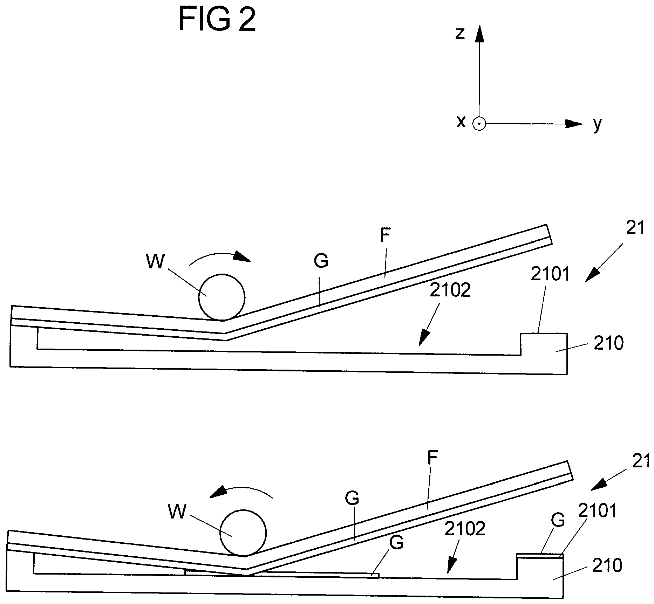

In Fig. 2 ist der vorstehend beschriebene Vorgang des Klebstoffübertrags bei einem anderen Fluidleitungsteil 21 gezeigt. Das Substrat 210 des Fluidleitungsteils 21 aus Fig. 2 weist im Vergleich zu jenem aus Fig. 1 eine deutlich breitere Vertiefung 2102 gegenüber der Oberfläche 2101 auf (bei einer ähnlichen Tiefe wie in Fig. 1). Dies hat zur Folge, dass die Folie F beim Abrollen auf den Boden des durch die Vertiefung 2102 gebildeten Kanals gedrückt wird und somit den Kanal mit Klebstoff G kontaminiert, wie im unteren Teil der Fig. 2 veranschaulicht. Dies kann zur Unbrauchbarkeit der gesamten mikrofluidischen Vorrichtung führen und soll daher vermieden werden.

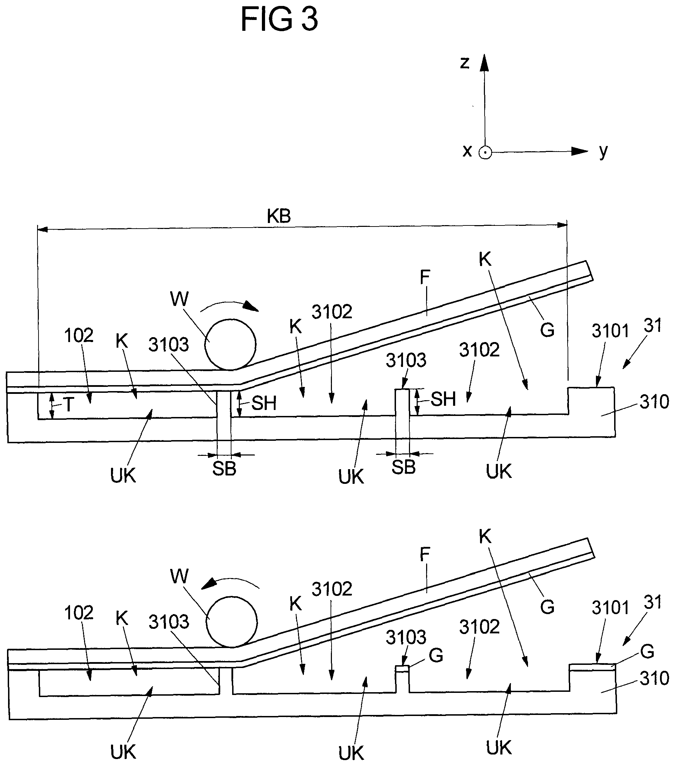

Fig. 3 veranschaulicht schematisch und exemplarisch einen Klebstoffübertrag bei einem Fluidleitungsteil 31 für eine mikrofluidische Vorrichtung 3 gemäß einer Ausführungsform der Erfindung, welche das vorstehend mit Bezug auf Fig. 2 erläuterte Problem löst.

Das Fluidleitungsteil 31 umfasst ein erstes Substrat 310, welches z. B. aus Glas, Silizium oder einem Kunststoff bestehen kann. In einer ersten Oberfläche 3101 des Substrats 310 sind Vertiefungen 3102 ausgebildet, welche gemeinsam einen Kanal K mit einer Kanalbreite KB bilden. Der Kanal K gibt eine Hauptstromrichtung X für ein Fluid vor.

In dem Kanal K sind erfindungsgemäß zwei Stützstege 3103 angeordnet, welche sich ihrer Länge nach entlang der Hauptstromrichtung X erstrecken. Beim Auftragen von Klebstoff G auf die verschiedenen koplanaren Abschnitte der ersten Oberfläche 3101 durch Abrollen einer mit dem Klebstoff G beschichteten Folie F verhindern die Stützstege, dass der Klebstoff G dem Boden des Kanals K in Kontakt kommt.

Die Stützstege 3103 sind bei der dargestellten beispielhaften Ausführungsform mit dem ersten Substrat 310 in einem Stück ausgebildet. Anders ausgedrückt sind die Stützstege 3103 gemeinsam mit dem Kanal K einstückig aus dem ersten Substrat 103 gefertigt worden, beispielsweise in einem fotolithographischen Ätzverfahren, bei welchem die Vertiefungen 3102 in der Weise definiert werden, dass die Stützstege 3103 stehen bleiben. Derartige Verfahren lassen sich insbesondere bei einem Substrat 310 aus Glas oder Silizium, etwa in Form eines Wafers, realisieren.

Die Querschnittsansicht in Fig. 3 veranschaulicht schematisch, dass eine jeweilige Stützstegbreite SB der Stützstege 3103 nur einen Bruchteil einer Kanalbreite KB beträgt, die der Kanal K insgesamt (wenigstens im Bereich der Stützstege 3103) aufweist. Es sollte jedoch beachtet werden, dass die Figuren hinsichtlich der Abmessungen nicht streng maßstabsgetreu zu verstehen sind, sondern vielmehr nur qualitativ die Strukturen und Relationen bei den dargestellten Ausführungsbeispielen verdeutlichen.

Bei dem Ausführungsbeispiel gemäß Fig. 3 beträgt die jeweilige Stützstegbreite SB weniger als ein Zehntel der Kanalbereite KB. Durch die im Vergleich zu der Kanalbreite KB geringe Stützstegbreite SB wird erreicht, dass die fluidischen Eigenschaften des in dem Fluidleitungsteil 31 ausgebildeten Kanals K nicht oder nur minimal negativ beeinflusst werden.

Durch die Stützstege 3103 kann auch bei einer vergleichsweise großen Kanalbreite KB und zugleich einer vergleichsweisen geringen Kanaltiefe T, wie in Fig. 3 schematisch veranschaulicht, ein Klebstoffübertrag mittels einer Folie F erfolgen, ohne dass der Kanal K beim Abrollen der Folie F mit Klebstoff G kontaminiert wird.

Beispielsweise kann bei der Ausführungsform nach Fig. 3 die Kanaltiefe T kleiner oder gleich 75 µm, insbesondere kleiner oder gleich 50 µm, wie z. B. kleiner oder gleich 5 µm sein. Die Kanalbreite KB kann demgegenüber z. B. wenigstens 2,5 mm betragen. So kann die Kanalbreite KB z. B. 2,5 mm sein, bei einer Kanaltiefe von 50 µm.

Eine jeweilige Stützsteghöhe SH der Stützstege 3103 ist dabei gemäß der vorliegenden Ausführungsform gleich der Kanaltiefe T. In anderen Ausführungsformen kann die Stützsteghöhe SH aber auch kleiner als die Kanaltiefe T sein.

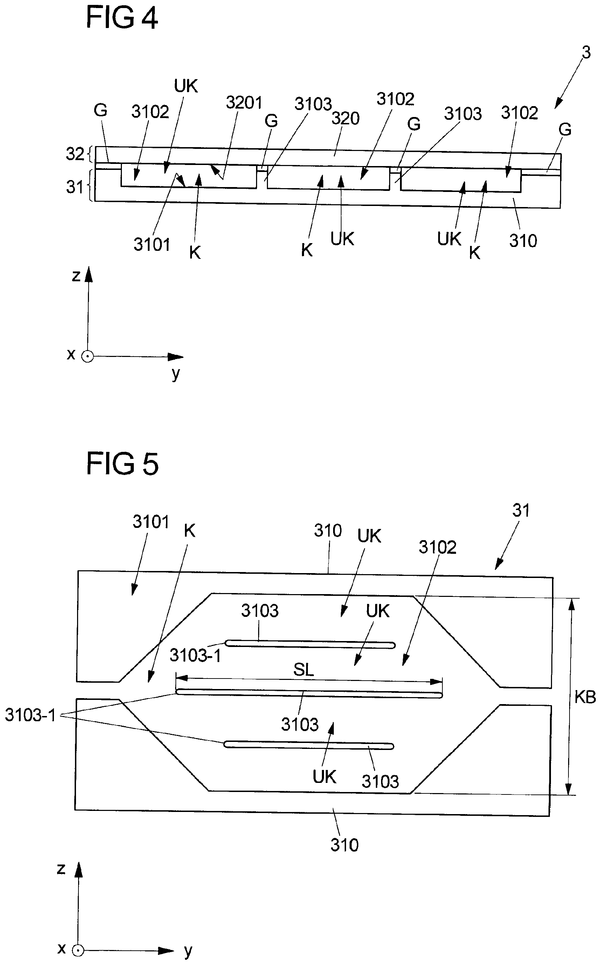

Fig. 4 veranschaulicht schematisch und exemplarisch eine Ausführungsform einer mikrofluidischen Vorrichtung 3 mit dem Fluidleitungsteil 31 aus Fig. 3 sowie einem darauf geklebten Verschlussteil 32, welches den Kanal K nach oben hin abschließt. Dabei ist eine zweite Oberfläche 3201 eines zweiten Substrats 320 auf die in dem in Fig. 3 gezeigten Klebstofftransferschritt mit Klebstoff G benetzten koplanaren Abschnitte der ersten Oberfläche 310 (zu welchen auch Oberflächenabschnitte der Stützstege 3103 zählen) geklebt worden.

Beispielsweise kann die mikrofluidische Vorrichtung 3 aus Fig. 4 in der Weise gefertigt worden sein, dass zunächst mehrere derartige Fluidleitungsteile 31 auf einem ersten Wafer bereitgestellt worden sind und dass mehrere derartige Verschlussteile 32 auf einem zweiten Wafer gefertigt worden sind, woraufhin der zweite Wafer im Ganzen auf den ersten Wafer geklebt worden ist. So können in besonders effizienter Weise in einem Schritt mehrere derartige mikrofluidische Vorrichtungen 3 gefertigt werden. Eine Vereinzelung der miteinander verklebten Wafer in mehrere mikrofluidische Vorrichtungen (etwa durch einen Säge- oder Lasertrennprozess) kann z. B. erst im Anschluss an das Klebebonden erfolgt sein.

Das Ausführungsbeispiel gemäß Fig. 4 zeigt auch, dass die Stützstege 3103 den Kanal K in einem Querschnitt senkrecht zu der Hauptstromrichtung X in drei gleich breite Unterkanäle UK unterteilen. Dabei sind zwei äußere Unterkanäle UK seitlich von einer jeweiligen Seitenwand des Kanals K und einer (äußeren) Seitenwand eines Stützstegs 3103 begrenzt, und ein innerer Unterkanal UK ist seitlich von zwei (inneren) Seitenwänden der benachbarten Stützstege 3103 begrenzt. Durch die äquidistante Positionierung der Stützstege über die Breite des Kanals K hinweg (d.h. entlang der Richtung Y quer zu der Hauptstromrichtung X) kann eine möglichst gute Stützwirkung für die Folie F beim Klebstoffübertrag erreicht werden, sodass man bei vorgegebener Kanalbreite KB und -tiefe T mit einer möglichst geringen Anzahl solcher Stützstege 3103 (hier nur zwei) auskommt.

Fig. 5 veranschaulicht schematisch und exemplarisch einer weiteren Ausführungsform eines erfindungsgemäßen Fluidleitungsteils 31 in einer Draufsicht. Diese Ausführungsform kann z. B. weitgehend der mit Bezug auf die Fig. 3 und 4 erläuterten Ausführungsform entsprechen, mit dem Unterschied, dass vorliegend drei nebeneinander verlaufende Stützstege 3103 vorgesehen sind.

Ähnlich wie bereits mit Bezug auf Fig. 4 beschrieben, unterteilen die drei Stützstege 3103 den Kanal K in einem Querschnitt senkrecht zu der Hauptstromrichtung X in mehrere (hier vier) gleich breite Unterkanäle UK.

Die Draufsicht gemäß Fig. 5 veranschaulicht ferner, dass eine jeweilige Stützsteglänge SL (entlang der Hauptstromrichtung X) erheblich größer als die Stützstegbreite SB (quer zu der Hauptstromrichtung, d.h. entlang der Richtung Y) ist. Beispielsweise kann ein Länge-zu-Breite-Verhältnis der Stützstege 3103 wenigstens 10, insbesondere wenigstens 33, wie z. B. wenigstens 50 betragen.

Bezogen auf das Ausführungsbeispiel in Fig. 5 können beispielhafte Abmessungen etwa derart sein, dass bei einer Länge des Kanals K von 10 mm die Kanaltiefe T 25 µm beträgt. Die Stützstegbreite SB kann z. B. 0,2 mm sein und die drei Stützstege 3103 können jeweils im Abstand von 2,2 mm voneinander bzw. von den Kanalwänden nebeneinander verlaufen.

Die Stützstege 3103 weisen an einem gegen die Hauptstromrichtung X weisenden Ende eine abgerundete Anströmkante 3103-1 auf, die in einer Draufsicht halbkreisförmig mit der halben Stützstegbreite SB (d. h. z. B. 0,1 mm) als Radius ausgeformt ist. Hierdurch kann ein vergleichsweise geringer Strömungswiderstand der Stützstege 3103 erreicht werden. Somit können die abgerundeten Anströmkanten 3103-1 dazu beitragen, dass die Stützstege 3103 frei umströmt werden, ohne die fluidischen Eigenschaften des Kanals K nennenswert negativ zu beeinflussen.

Bei der in Fig. 5 dargestellten Ausführungsvariante ist auch das jeweils andere Ende der Stützstege 3103, also das in die Hauptstromrichtung X weisenden Ende, mit einer solchen abgerundeten Anströmkante versehen. Dies kann zu einer besonders widerstandsarmen, laminaren Umströmung der Stützstege 3103 beitragen. Insbesondere kann durch abgerundete Anströmkanten 3103 einer Vermeidung von Verwirbelungen des Fluides oder von Anhaften von Luftblasen beim Befüllen im Bereich der Stützstege 3103 beigetragen werden.

### Bezugszeichenliste

- 11: Fluidleitungsteil
- 110: Substrat
- 1101: Oberfläche
- 1102: Vertiefung

- 21: Fluidleitungsteil
- 210: Substrat
- 2101: Oberfläche
- 2102: Vertiefung

- 31: Fluidleitungsteil
- 310: erstes Substrat
- 3101: erste Oberfläche
- 3102: Vertiefung
- 3103: Stützsteg
- 3103-1: Anströmkante

- 32: Verschlussteil
- 320: zweites Substrat
- 3201: zweite Oberfläche

- B: Boden des Kanals
- F: Folie
- G: Klebstoff
- K: Kanal
- KB: Kanalbreite
- SB: Stützstegbreite
- SL: Stützsteglänge
- SH: Stützsteghöhe
- T: Kanaltiefe
- UK: Unterkanal
- W: Walze
- X: Hauptstromrichtung

## Patentansprüche

1. Fluidleitungsteil (31) für eine mikrofluidische Vorrichtung (3), umfassend
ein erstes Substrat (310) mit einer ersten Oberfläche (3101), in der wenigstens eine Vertiefung (3102) ausgebildet ist, wobei die wenigstens eine Vertiefung (3102) einen Kanal (K) zum Leiten eines Fluids entlang einer Hauptstromrichtung (X) ausbildet;
**gekennzeichnet durch**
wenigstens einen Stützsteg (3103), der sich innerhalb des Kanals (K) der Länge nach entlang der Hauptstromrichtung (X) erstreckt, wobei der Stützsteg (3103) in der Weise ausgebildet und angeordnet ist, dass er von dem Fluid frei umströmt wird.

2. Fluidleitungsteil (31) nach Anspruch 1, **dadurch gekennzeichnet, dass** eine Stützstegbreite (SB) des wenigstens einen Stützstegs (103) höchstens ein Zehntel einer Kanalbreite (KB) des Kanals (K) im Bereich des wenigstens einen Stützstegs (103) beträgt.

3. Fluidleitungsteil (31) nach einem der vorangehenden Ansprüche, **dadurch gekennzeichnet, dass** der wenigstens eine Stützsteg (3103) mit dem ersten Substrat (310) in einem Stück ausgebildet ist.

4. Fluidleitungsteil (1) nach einem der vorangehenden Ansprüche, **dadurch gekennzeichnet, dass** der wenigstens eine Stützsteg (3103) an einem gegen die Hauptstromrichtung (X) weisenden Ende eine abgerundete Anströmkante (3103-1) aufweist.

5. Fluidleitungsteil (1) nach einem der vorangehenden Ansprüche, **gekennzeichnet durch,** zwei oder mehr derartige Stützstege (3103), die sich der Länge nach nebeneinander in dem Kanal (K) erstrecken.

6. Fluidleitungsteil (31) nach einem der vorangehenden Ansprüche, **dadurch gekennzeichnet, dass** der oder die Stützstege (3103) den Kanal (K) in einem Querschnitt senkrecht zu der Hauptstromrichtung (X) in mehrere gleich breite Unterkanäle (UK) teilt bzw. teilen.

7. Fluidleitungsteil (31) nach einem der vorangehenden Ansprüche, **dadurch gekennzeichnet, dass** eine Kanaltiefe (T) des Kanals (K) kleiner oder gleich 75 µm ist.

8. Fluidleitungsteil (31) nach einem der vorangehenden Ansprüche, **dadurch gekennzeichnet, dass** die Kanalbreite (KB) wenigstens 1,0 mm ist.

9. Fluidleitungsteil (31) nach einem der vorangehenden Ansprüche, **dadurch gekennzeichnet, dass** ein Verhältnis einer Stützstegbreite (SB) des wenigstens einen Stützstegs (3103) zu einer Stützsteghöhe(SH) des wenigstens einen Stützstegs (3103) größer als 1 ist.

10. Fluidleitungsteil (31) nach einem der vorangehenden Ansprüche, **dadurch gekennzeichnet, dass** das erste Substrat (310) aus Glas, Silizium oder Kunststoff besteht.

11. Mikrofluidische Vorrichtung (3), umfassend
- ein Fluidleitungsteil (31) nach einem der vorangehenden Ansprüche; und
- ein Verschlussteil (32), das ein zweites Substrat (320) mit einer zweiten Oberfläche (3201) umfasst,
wobei die zweite Oberfläche (3201) wenigstens abschnittsweise auf die erste Oberfläche (3101) aufgeklebt ist.

12. Verfahren zur Fertigung einer mikrofluidischen Vorrichtung (3), umfassend:
- Bereitstellen eines Fluidleitungsteils (31), das Folgendes umfasst:
o ein erstes Substrat (310) mit einer ersten Oberfläche (3101), in der wenigstens eine Vertiefung (3102) ausgebildet ist, wobei die wenigstens eine Vertiefung (3102) einen Kanal (K) zum Leiten eines Fluids entlang einer Hauptstromrichtung (X) ausbildet; und
o wenigstens einen frei vom Fluid umströmten Stützsteg (3103) innerhalb des Kanals (K);
- Auftragen von Klebstoff (G) auf die erste Oberfläche (3101) durch Abrollen einer mit dem Klebstoff (G) beschichteten Folie (F) auf der ersten Oberfläche (3101), wobei der Stützsteg (3103) verhindert, dass die mit dem Klebstoff (G) beschichtete Folie (F) mit einem Boden (B) des Kanals (K) in Kontakt kommt.

13. Verfahren nach Anspruch 12, ferner umfassend:
- Bereitstellen eines Verschlussteils (32), das ein zweites Substrat (320) mit einer zweiten Oberfläche (3201) umfasst; und
- Aufkleben der zweiten Oberfläche (3201) des Verschlussteils (32) auf die erste Oberfläche (3101) des Fluidleitungsteils (31) mittels des Klebstoffs (G).

14. Verfahren nach Anspruch 13, **dadurch gekennzeichnet, dass** mehrere derartige Fluidleitungsteile (31) auf einem ersten Wafer sowie mehrere derartige Verschlussteile (32) auf einem zweiten Wafer bereitgestellt werden und dass der zweite Wafer auf den ersten Wafer geklebt wird.

15. Verfahren nach einem der Ansprüche 12 bis 14, ferner umfassend das Fertigen des Fluidleitungsteils (31), **dadurch gekennzeichnet, dass** der wenigstens eine Stützsteg (3103) mit dem ersten Substrat (310) in einem Stück ausgebildet wird.
